# EUROPEAN PATENT APPLICATION

(11) **EP 3 018 232 A1**
(43) Date of publication of application: **11.05.2016**
(21) Application number: 15192895.9
(22) Date of filing: 04.11.2015
(51) Int. Cl.: C23C 14/24, C23C 14/34, C23C 22/05, H01F 1/053, H01F 41/02

(54) **ND-FE-B MAGNET WITH ALUMINUM HARD FILM COATING AND PREPARATION METHOD THEREOF**

(30) Priority: 04.11.2014 CN 201410610935
(71) Applicant: Yantai Shougang Magnetic Materials Inc., 265500 Yantai (CN)
(72) Inventor: YANG, Kunkun, Yantai City 265500 (CN); PENG, Zhongjie, Yantai City 265500 (CN)
(74) Representative: Gulde & Partner

(57) **Abstract**

The present invention provides a method for forming an aluminum hard film coating on the surface of Nd-Fe-B magnets. The method includes the following process steps:
a) vacuum plating of aluminum on the surface of Nd-Fe-B magnet thereby forming an aluminum film; and
b) forming an aluminum oxide layer on the surface of the aluminum film by anodic oxidation.

## Description

The present invention relates to an anticorrosive coating for Nd-Fe-B magnets and a corresponding preparation method thereof.

### Technological Background

Due to the potential difference between the Nd-rich phase and Nd₂Fe₁₄B phase, and possible hydrogen absorption, an Nd-Fe-B magnet is very easily to corrode. Forming an anticorrosive coating on the surface of the Nd-Fe-B magnet is one of the most effective ways for preventing Nd-Fe-B magnets from corrosion.

Forming an anticorrosive coating by electroplating of aluminum is widely used. However, the use of electroplating is restricted because of environment reasons and due to possible damaging of the magnet. Further coating methods, which are usually used to form an aluminum film on the surface of the Nd-Fe-B magnet as an anticorrosion coating, include arc ion plating, magnetron sputtering, magnetic control arc ion plating, and vacuum evaporation. However, the aluminum film formed by these common coating processes is mechanical weak and could be easily damaged.

### Summary of Invention

The present invention provides a method for forming an aluminum hard film coating on the surface of Nd-Fe-B magnets, and aims to overcome the shortcoming of above-mentioned technologies. The method includes the following process steps:
a) vacuum plating of aluminum on the surface of Nd-Fe-B magnet thereby forming an aluminum film; and
b) forming an aluminum oxide layer on the surface of the aluminum film by anodic oxidation.

Step a) includes coating of an aluminum film of the Nd-Fe-B magnet in conventional manner. In step b), the Nd-Fe-B magnet is set as anode and put into an appropriate electrolyte. During the anodic oxidation an aluminum oxide layer is formed on the surface of aluminum film.

Preferably, vacuum plating of aluminum in step a) is performed by arc ion plating, magnetron sputtering, magnetic control arc ion plating, or vacuum evaporation.

A thickness of the aluminum film of step a) may be 5 to 40µm.

The anodic oxidation in step b) may be performed in an electrolyte including one or more of sulfuric acid, chromic acid, boric acid and oxalic acid.

Another aspect of the present invention is an Nd-Fe-B magnet with an aluminum hard film coating, which is obtained by performing the before mentioned method.

The inventive method has several advantages. The process is quite simple and can be easily implemented in an industrial manufacturing process. Moreover, the coating showed a high corrosion resistance and the hardness of inventive anticorrosion film is increased 8 times compared to a conventional aluminum film.

### Brief Description of the Drawings

Figure 1 is a sectional view of an aluminum hard film formed by partial anodic oxidation of an aluminum film on the surface of an Nd-Fe-B magnet according to the present invention.
Figure 2 is a component analysis diagram of the coating of the magnet illustrated in Figure 1.
Figure 3 is a photo of a micro hardness indentation formed in the inventive aluminum hard film as an anticorrosion coating on an Nd-Fe-B magnet.
Figure 4 is a photo of a micro hardness indentation formed in a conventional aluminum film as an anticorrosion coating on an Nd-Fe-B magnet.
Figure 5 is comparative test of hardness of the conventional aluminum film and the aluminum hard film according to the invention.

### Detailed Description of the Invention

The invention will now be described in detailed embodiments, which should not be construed to be limiting.

### Example 1

A sample of an Nd-Fe-B magnet, which has been grinded, polished, and cleaned by alcohol, is put into a vacuum furnace for arc ion plating. Vacuuming indoor pressure is 5 x 10⁻³ to 5.5 x 10⁻³ Pa and voltage is 400 V for 10 min. The multi arc ion source is started and kept working for 200min. The current is 60 A and kept for 60s. Then the bias voltage is adjusted to 100 V to complete the preparation aluminum film on the surface of the Nd-Fe-B magnet. The thickness of aluminum layer is greater than 5 microns.

The preparation method for the oxidation film on the aluminum film of the Nd-Fe-B magnet includes: setting the Nd-Fe-B magnet which is coated by the aluminum film as anode and putting the same into an electrolyte consisting of 15 % sulfuric acid solution (weight percent). The aluminum oxidation film will be formed on the surface of aluminum film by anodic oxidation. The temperature of the sulfuric acid solution is 18 to 20 °C, the anodic oxidation voltage control is 12 V and the anodic oxidation is upheld for 2 min.

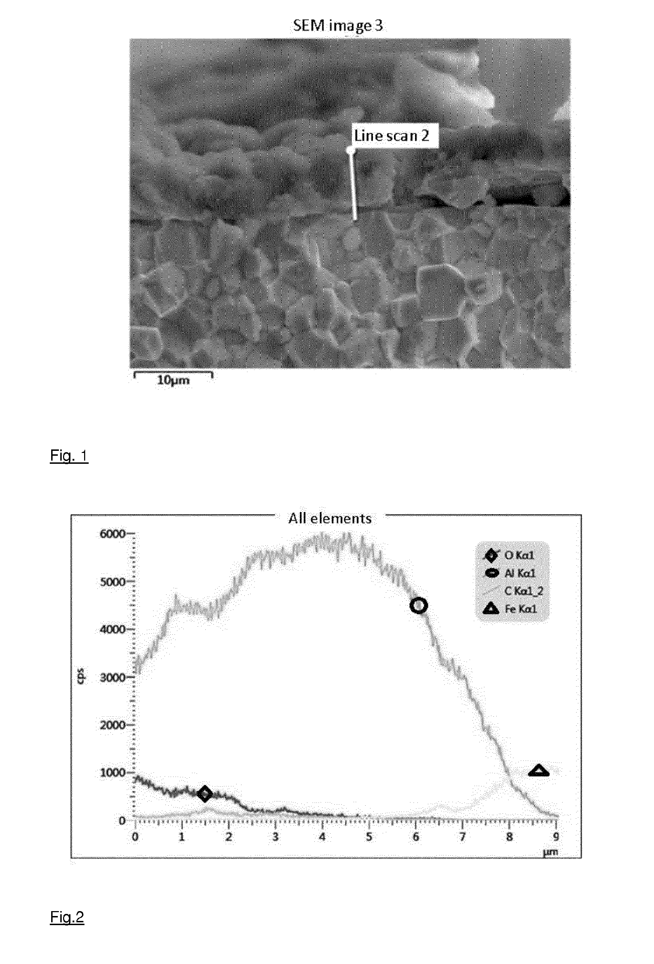

A sectional view and the component analysis of the aluminum hard film layer are shown in Figure 1 and Figure 2 respectively. A boundary between the aluminum film and the aluminum oxide layer thereon could be seen from Figure 1. Figure 2 shows that the oxygen content decreases with the depth, i.e. aluminum oxide was generated on the upper surface of the aluminum film. Hence, the aluminum hard film consists of an aluminum film and an aluminum oxide layer formed thereon.

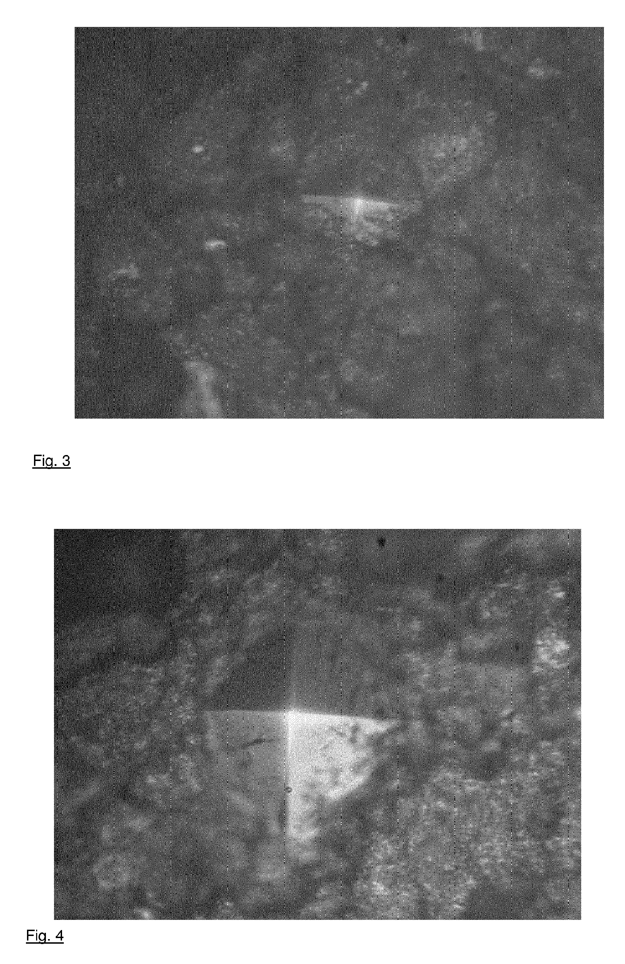

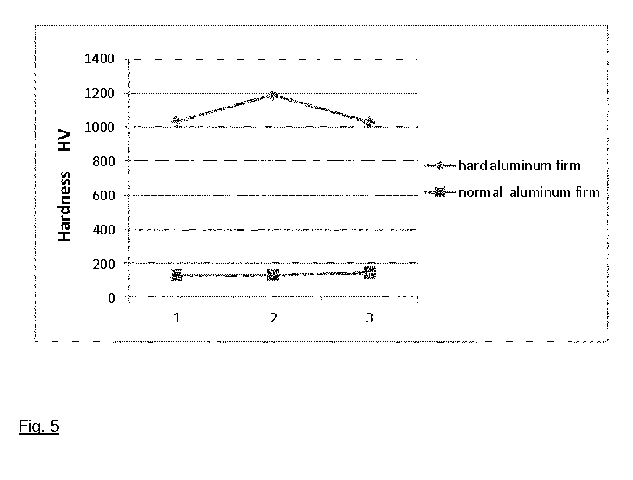

Figure 3 and Figure 4 show micro hardness indentations of the conventional aluminum film and the inventive aluminum hard film. Figure 5 illustrates the hardness of the aluminum film and the aluminum hard film (Vickers hardness test). The indentation on the surface of the hard film (Figure 3) was much smaller than on the surface of a conventional pure aluminum film (Fig. 4). The average micro hardness of the aluminum hard film was about 8 times of conventional aluminum film and reached 1082 VH.

### Example 2

A sample of an Nd-Fe-B magnet, which has been grinded, polished, and cleaned by alcohol, is put into a vacuum furnace for arc ion plating. Vacuuming indoor pressure is 2 x 10⁻³ Pa and voltage is 350 V for 15 min. The multi arc ion source is started and kept working for 100min. The current is 50 A and kept for 70s. Then the bias voltage is adjusted to 100 V to complete the preparation aluminum film on the surface of the Nd-Fe-B magnet. The thickness of aluminum layer is greater than 5 microns.

The preparation method of the oxidation film on the aluminum film of the Nd-Fe-B magnet includes: setting the Nd-Fe-B magnet which is coated by the aluminum film as anode and putting the same into an electrolyte consisting of 18 % sulfuric acid solution (weight percent). The aluminum oxidation film will be formed on the surface of aluminum film by anodic oxidation. The temperature of the sulfuric acid solution is 18 to 20 °C, the anodic oxidation voltage control is 15 V and the anodic oxidation is upheld for 3 min.

### Example 3

A sample of an Nd-Fe-B magnet, which has been grinded, polished, and cleaned by alcohol, is put into a vacuum furnace for arc ion plating. Vacuuming indoor pressure is 9 x 10⁻³ Pa and voltage is 650 V for 10 min. The multi arc ion source is started and kept working for 100min. The current is 70 A and kept for 50s. Then the bias voltage is adjusted to 200 V to complete the preparation aluminum film on the surface of the Nd-Fe-B magnet. The thickness of aluminum layer is greater than 5 microns.

The preparation method of the oxidation film on the aluminum film of the Nd-Fe-B magnet includes: setting the Nd-Fe-B magnet which is coated by the aluminum film as anode and putting the same into an electrolyte consisting of 20 % sulfuric acid solution (weight percent). The aluminum oxidation film will be formed on the surface of aluminum film by anodic oxidation. The temperature of the sulfuric acid solution is 18 to 20 °C, the anodic oxidation voltage control is 20 V and the anodic oxidation is upheld for 5 min.

### Example 4

The aluminum film on the surface of Nd-Fe-B magnets is made by arc ion plating in the same manner as in Example 1. The electrolyte includes a mixture of chromic acid, boric acid and oxalic acid and the parameters for forming the aluminum oxide layer are the same as in Example 3.

## Claims

1. A method for forming an aluminum hard film coating on a surface of an Nd-Fe-B magnet, the method including the following process steps:
a) vacuum plating of aluminum on the surface of Nd-Fe-B magnet thereby forming an aluminum film; and
b) forming an aluminum oxide layer on the surface of the aluminum film by anodic oxidation.

2. The method of claim 1, wherein vacuum plating of aluminum in step a) is performed by arc ion plating, magnetron sputtering, magnetic control arc ion plating, or vacuum evaporation.

3. The method of claim 1, wherein a thickness of the aluminum film of step a) is 5 to 40 µm.

4. The method of claim 1, wherein the anodic oxidation in step b) is performed in an electrolyte including one or more of sulfuric acid, chromic acid, boric acid and oxalic acid.

5. Nd-Fe-B magnet with an aluminum hard film coating obtained by the method according to any of the preceding claims.
